(19) 

**Europäisches Patentamt**
**European Patent Office**
**Office européen des brevets**

(11) **EP 1 204 120 B1**

(12) **EUROPÄISCHE PATENTSCHRIFT**

(45) Veröffentlichungstag und Bekanntmachung des
Hinweises auf die Patenterteilung:
**10.10.2007 Patentblatt 2007/41**

(51) Int Cl.:
***G11C 11/16*** *(2006.01)*

(21) Anmeldenummer: **01119075.8**

(22) Anmeldetag: **07.08.2001**

(54) **Magnetoresistiver Speicher und Verfahren zu seinem Auslesen**

Magnetoresistive memory and reading method

Mémoire magnétorésistive et méthode de lecture

(84) Benannte Vertragsstaaten:
**DE FR GB IE IT**

(30) Priorität: **04.09.2000 DE 10043440**

(43) Veröffentlichungstag der Anmeldung:
**08.05.2002 Patentblatt 2002/19**

(73) Patentinhaber: **Qimonda AG**
**81739 München (DE)**

(72) Erfinder:
• **Thewes, Roland, Dr.**
**82194 Gröbenzell (DE)**

• **Weber, Werner, Dr.**
**80637 München (DE)**
• **Van Den Berg, Hugo, Dr.**
**8355 Diethoorn (NL)**

(74) Vertreter: **Müller - Hoffmann & Partner**
**Patentanwälte,**
**Innere Wiener Strasse 17**
**81667 München (DE)**

(56) Entgegenhaltungen:
**US-B1- 6 259 644**

## Beschreibung

Die Erfindung betrifft einen magnetoresistiven Speicher und ein Verfahren zum Auslesen von Speicherzellen in einem solchen magnetoresistiven Speicher.

Magnetoresistive Speicher stellen eine Alternative zu herkömmlichen DRAM- und SRAM-Speichern sowie zu nichtflüchtigen Speichern, beispielsweise Flash oder EEPROM, dar. Sie bestehen aus einer Anordnung von Speicherzellen, an die Bitleitungen und Wortleitungen herangeführt sind. Die einzelne Speicherzelle eines magnetoresistiven Speichers besteht aus zwei magnetischen Elementen, welche durch ein Dielektrikum voneinander getrennt sind. Eines der magnetischen Elemente ist hartmagnetisch und somit in seiner Magnetflußrichtung vorgegeben, das andere ist weichmagnetisch und kann durch Anlegen geeigneter Schaltströme an die Bit- und Wortleitungen in seiner Orientierung umgekehrt werden. Das zwischen den beiden magnetischen Elementen angeordnete Dielektrikum ist ein sogenanntes Tunneldielektrikum, beispielsweise eine als Tunneldielektrikum geeignete Schicht von 2 nm Dicke. Das Tunneldielektrikum weist als Besonderheit einen Widerstand auf, welcher abhängig ist von dem ihn umgebenden Magnetfeld. Wenn beide magnetischen Elemente auf beiden Seiten des Tunneldielektrikums gleichsinnig orientiert sind, weist das Dielektrikum einen anderen Widerstandswert auf als wenn die Magnetflußrichtungen der beiden magnetischen Elemente zueinander invertiert sind. Durch Anlegen einer geeigneten Spannung an die Bitleitungen und Wortleitungen kann der jeweils im Tunneldielektrikum aktuelle Wert des Widerstandes bestimmt werden und somit auf die Orientierung der magnetischen Elemente geschlossen werden. Insgesamt ergibt sich daher ein binär arbeitendes Zustandssystem, das somit zur Speicherung digitaler Informationen geeignet ist.

Bei einer solchen Anordnung von Speicherzellen bietet es sich beispielsweise an, jeweils über und unter den eigentlichen Speicherzellen parallel laufende Bit- beziehungsweise Wortleitungen vorzusehen, die zueinander wiederum rechtwinklig angeordnet sind. Am Rand der Speicherzellenanordnung können die Bitleitungen und Wortleitungen dann in zusätzliche Schaltungen zum Schreiben und Lesen überführt werden.

Arrays von MRAM-Massenspeichern wurden bislang noch nicht als Produkte vorgestellt. Es sind lediglich kleinere Anordnungen (Arrays) verfügbar, die zumeist auf dem Prinzip "Current In-Plane" beruhen, während dem Prinzip "Current Perpendicular to Plane" für Massenspeicheranwendungen größere Chancen gegeben werden. Magnetoresisitve Speicher bieten bestimmte prinzipielle Vorteile, wie einfache Fertigung, nichtflüchtige Datenerhaltung und gute Shrinkeignung. Ihre Eignung als Massenspeicher hängt in hohem Maße davon ab, ob ausreichend große Speicherzellenblöcke verwirklicht werden können. Anordnungen (Arrays) von konkurrenzfähigen Massenspeichern müssen folgende Anforderungen gleichzeitig erfüllen:

1. Das Array muss eine Größe von (einigen hundert) x (einigen hundert) Speicherzellen erlauben.
2. Das Lesesignal muss eine bestimmte Mindestgröße haben, um eine hinreichend sichere Bewertung zu ermöglichen. Beispiele von HL Produkten:

- DRAMs benötigen ca. 100-150 mV. Sie führen Spannungsbewertung am Arrayrand durch mit Leseverstärkern, die im Pitch sitzen.
- Flash-Speicher (embedded) benötigen ca. 10 $\mu$A. Sie führen Strombewertung mit Leseverstärkern in der Peripherie durch.
- SRAMs arbeiten mit On-Strömen von 150 $\mu$A und vernachlässigbaren Off-Strömen. Sie erreichen Arrayzugriffszeiten von 600 ps - 1.2 ns.

Genaue Werte können für MRAM nicht a priori angegeben werden, sondern es muß fallweise geprüft werden, ob das Lesesignal für eine zuverlässige störunempfindliche Bewertung ausreicht. Es ist jedenfalls kein Leseverstärker im Pitch notwendig. Das relaxiert die Anforderungen.
3. Der Energieverbrauch beim Lesen sollte mit dem von DRAM vergleichbar oder niedriger sein (je nach Architektur 1pJ - 1nJ).

Diese Forderungen müssen auch an eine Massenspeicheranwendung von MRAMs gestellt werden.

Im Stand der Technik sind verschiedene Vorschläge unterbreitet worden, um magnetoresistive Speicherzellenanordnungen zu konfigurieren. Die dort vorgestellten Verstärkerschaltungen neigen jedoch in der Anwendung zu Stabilitätsproblemen.

Im einzelnen ist aus der EP-A-1152429, ein A 54(3) EPÜ Dokument, die Verwendung eines Impedanzwandlers zum Puffern einer Lesespannung einer auszulesenden Speicherzelle eines magnetoresistiven Speichers und zum Anlegen des gepufferten Signals an Wort- und Bitleitungen dieses Speichers bekannt.

Es ist Aufgabe der vorliegenden Erfindung, eine geeignete Architektur zum zuverlässigen Beschreiben, Lesen und Löschen von magnetoresistiven Speicherzellen in Anordnungen von Speicherzellen von magnetoresistiven Speichern bereitzustellen.

Erfindungsgemäß wird diese Aufgabe gelöst durch die Bereitstellung eines magnetoresistiven Speichers gemäß dem unabhängigen Patentanspruch 1 und eines Verfahrens zum Auslesen von Speicherzellen gemäß dem unabhängigen Patentanspruch 10. Weitere vorteilhafte Ausgestaltungen und Aspekte und Details der Erfindung ergeben sich aus den abhängigen Patentansprüchen, der Beschreibung und den beigefügter Zeichnungen.

Der Erfindung liegt das Prinzip zugrunde, eine Spannung zu generieren, welche abhängig vom Widerstand einer auszulesenden Speicherzelle ist, und diese Spannung über einen Impedanzwandler so belastbar zu machen, daß die Wort- und Bitleitungen hinreichend auf einem stabilen Spannungslevel gehalten werden können.

Daher ist die Erfindung zunächst gerichtet auf einen magnetoresistiven Speicher mit einer Anordnung von in einer Mehrzahl von Reihen und/oder einer Mehrzahl von Spalten angeordneten magnetoresistiven Speicherzellen, einer Bitleitung für jede der Spalten, die mit ersten Polen der zu der Spalte gehörenden Speicherzellen verbunden ist, einer Wortleitung für jede der Reihen, die mit zweiten Polen der zu der Reihe gehörenden Speicherzellen verbunden ist, einer Lesespannungsquelle, die mit ersten Enden der Wortleitungen durch Schaltelemente einzeln verbindbar ist, einem Spannungsbewerter, dessen zumindest einer Eingang über eine Bewertungsleitung mit ersten Enden der Bitleitungen durch Schaltelemente einzeln verbindbar ist, wobei von der Bewertungsleitung ein erster Abschlußwiderstand abzweigt. Der erfindungsgemäße magnetoresistive Speicher ist gekennzeichnet durch einen Impedanzwandler, dessen Eingang mit der Bewertungsleitung verbunden ist und dessen Ausgang mit zweiten Enden der Bitleitungen und Wortleitungen durch Schaltelemente einzeln verbindbar ist.

Die in einer Anordnung organisierte Mehrzahl von Speicherzellen verfügt über Reihen und Spalten. Da zur Durchführung des erfindungsgemäßen Verfahrens und damit zur erfindungsgemäßen Anwendung des Impedanzwandlers eine Spannung an solche Wort- und Bitleitungen angelegt wird, die nicht mit der auszulesenden Speicherzelle verbunden sind, folgt, daß zumindest in einer der beiden angegebenen Dimensionen, also bei Reihen oder bei Spalten, mehr als eine Leitung vorhanden sein muß. Die Mindestzahl von Speicherzellen, bei denen die Erfindung sinnvoll einsetzbar ist, beträgt somit zwei. Wünschenswert ist selbstverständlich eine höhere Zahl von Speicherzellen, die in aller Regel in der Praxis auch gegeben sein wird.

Die mit den Wortleitungen verbindbare Lesespannungsquelle ist in der Lage, eine Spannung den beziehungsweise der aktivierten Wortleitung(en) zu vermitteln, welche hinreichend ist, um die noch am Spannungsbewerter anliegende Spannung durch den Spannungsbewerter bestimmen zu lassen. Der von der Bewertungsleitung abzweigende erste Abschlußwiderstand ist also zum Spannungsbewerter parallel geschaltet. Am Abschlußwiderstand und am Spannungsbewerter liegt somit die gleiche Spannung an. Die Größe der Spannung ergibt sich aus dem Verhältnis des ersten Abschlußwiderstands und dem in der auszulesenden Speicherzelle aktuell vorhandenen Widerstandswert.

Ein Impedanzwandler im Sinne der vorliegenden Erfindung wird auch als V=1-Verstärker oder als Spannungsfolger ohne Pegelversatz bezeichnet. Er verändert nicht die an seinem Eingang anliegende Spannung (welche identisch ist mit der über den ersten Abschlußwiderstand abfallenden Spannung), sondern gibt an seinem Ausgang eine identische Spannung aus, wobei jedoch das dort anliegende Signal niederohmig ist und daher belastbarer. Somit steht eine hinreichend niederohmige Spannungsquelle zur Verfügung, um an die dafür vorgesehenen Wort- und Bitleitungen eine identische Spannung anzulegen.

Unter einem Abschlußwiderstand ist ein Widerstand zu verstehen, dessen einer Pol mit der zu bewertenden Spannung und dessen anderer Pol mit einer Referenzspannung verbunden ist. In der Regel handelt es sich bei der Referenzspannung um GND, es ist jedoch auch eine andere Spannung möglich, beispielsweise auch eine, welche höher ist als diejenige der Lesespannungsquelle. In diesem Fall muß die Schaltung entsprechend angepasst werden, was dem Fachmann als Maßnahme geläufig ist.

Der magnetoresistive Speicher kann vorzugsweise so ausgestaltet sein, daß die Bewertungsleitung eine Anschlußleitung zur Verbindung mit den Bitleitungen und zwei Bewertungspfade, die durch Schaltelemente mit der Anschlußleitung einzeln verbindbar sind, aufweist, wobei von den Bewertungspfaden je ein Abschlußwiderstand abzweigt, wobei jeder der beiden Bewertungspfade durch je ein Schaltelement mit einem Eingang des Spannungsbewerters und einer dazu parallelen Kapazität verbindbar ist und jeder der beiden Bewertungspfade durch je ein Schaltelement mit dem Eingang des Impedanzwandlers und einer zu diesem Eingang parallelen Kapazität verbindbar ist.

Durch diese bevorzugte Anordnung von Elementen ergeben sich effektiv zwei Bewertungspfade anstelle des oben skizzierten einen Bewertungspfads, welche jeweils mit der/den für das Auslesen der Speicherzelle maßgeblichen Bitleitungen, dem Impedanzwandler und dem Spannungsbewerter verbindbar sind. Auf diese Weise ist es möglich, zwei voneinander unabhängige Bewertungen des an der auszulesenden Speicherzelle vorhandenen Widerstands durchzuführen.

Hierbei können die beiden Abschlußwiderstände einen identischen Widerstandswert aufweisen oder sich in ihren Widerstandswerten unterscheiden. Die beiden vorhandenen Kapazitäten dienen dazu, die aufgetretenen Spannungen während der Messung zwischenzuspeichern, so daß in einem entsprechenden Spannungsbewerter mit zwei Eingängen ein Vergleich der beiden Spannungen durchgeführt werden kann. Die Anordnung von zwei voneinander unabhängigen Bewertungspfaden ermöglicht beispielsweise das zweifache Bewerten einer Speicherzelle und eine Mittelwertbildung, aus der sich mit größerer Genauigkeit der Widerstandswert und damit der binäre Sinngehalt der Speicherzelle ermitteln läßt.

Es ist jedoch auch möglich, zwischen den beiden Bewertungen einen Umschaltversuch einzufügen, um aus einer sich gegebenenfalls ergebenden Änderung des Widerstandswerts der auszulesenden Speicherzelle auf den vormaligen binären Zustand der Speicherzelle rückschließen zu können. Um einen solchen Umschaltversuch vornehmen zu können, weist der erfindungsgemäße magnetoresistive Speicher vorzugsweise weiterhin auf: eine erste Schreibstromquelle, die mit den ersten Enden der Wortleitungen durch Schaltelemente einzeln verbindbar ist, und eine zweite Schreibstromquelle, die mit den ersten Enden der Bitleitungen durch Schaltelemente einzeln verbindbar ist. Durch die Schreibstromquellen in Verbindung mit dem Anlegen einer vom Impedanzwandler bereitgestellten Spannung an die auszulesende Speicherzelle kann ein solcher Umschaltversuch in einer bestimmten Richtung durchgeführt werden.

Wie beschrieben, müssen Lesespannungsquelle, Schreibstromquellen, der Ausgang des Impedanzwandlers sowie die Bewerterleitung und die daran hängenden Bewerterpfade einzeln mit den jeweils verwendeten Enden der Wort- und Bitleitungen verbindbar sein. Zu diesem Zweck werden Verteiler bereitgestellt, welche die ein- und auslaufenden Signale und Spannungen zu den verschiedenen Wort- und Bitleitungen bringen. Bei den Verteilern handelt es sich somit um verzweigte Leiterbahnsysteme, an deren Enden günstigerweise die Schaltelemente zur Verbindung mit den Wort- und Bitleitungen angeordnet sind. Demnach kann die Verbindung der Bitleitungen mit der Bewertungsleitung durch einen Bewerterverteiler mit einem Schaltelement für jede der Bitleitungen erfolgen. Die Verbindung der Bitleitungen mit der zweiten Schreibstromquelle kann ebenfalls durch den Bewerterverteiler erfolgen, wobei die zweite Schreibstromquelle und die Bewerterleitung durch Schaltelemente mit dem Bewerterverteiler verbindbar sind. Die Schaltelemente zur Verbindung von Schreibstromquelle und Bewerterleiter mit dem Bewerterverteiler diesen dazu, einen der beiden Kontakte alternativ herstellen zu können, da es nicht sinnvoll ist eine direkte elektrische Verbindung zwischen Bewerterschaltung und Schreibstromquelle zuzulassen.

Die Verbindung des Ausgangs des Impedanzwandlers mit den Bit- und Wortleitungen kann durch einen Pufferverteiler erfolgen, der mit einem Schaltelement für jede Bit- und Wortleitung ausgestattet ist.

Ebenso kann die Verbindung der Lesespannungsquelle mit den Wortleitungen durch einen Leseverteiler, ebenfalls mit einem Schaltelement für jede Wortleitung erfolgen.

Schließlich kann die Verbindung der ersten Schreibstromquelle mit den Wortleitungen ebenfalls durch den Leseverteiler erfolgen, wobei die erste Schreibstromquelle und die Lesespannungsquelle, in ähnlicher Weise wie bereits die zweite Schreibstromquelle und die Bewerterleitung, durch Schaltelemente mit dem Leseverteiler verbindbar sein.

Vorzugsweise werden die oben erwähnten Schaltelemente zumindest teilweise, vorzugsweise jedoch insgesamt als Transistoren ausgebildet sein.

Die zum Einsatz kommenden magnetoresistiven Speicherzellen sind vorzugsweise sogenannte Vertikalspannungsspeicherzellen (Current Perpendicular to Plane). Bei diesen sind die Speicherelemente Bitleitung, erstes magnetisches Element, Tunneldielektrikum, zweites magnetisches Element und Wortleitung vertikal übereinander, bezogen auf eine Oberfläche in einem integrierten Schaltkreis (respektive seinen Siliziumstrukturen) angeordnet. Bei der Bewertung fließt der Strom somit von oben nach unten oder von unten nach oben.

Die Erfindung ist weiterhin auf ein Verfahren zum Auslesen magnetoresistiver Speicher gerichtet. Bezüglich des Verfahrens gilt alles oben hinsichtlich der Vorrichtung Gesagte, wobei darauf vollinhaltlich Bezug genommen wird.

Die Erfindung ist gerichtet auf ein Verfahren zum Auslesen von Speicherzellen in einem magnetoresistiven Speicher mit einer Anordnung von in einer Mehrzahl von Reihen und/oder einer Mehrzahl von Spalten angeordneten magnetoresistiven Speicherzellen; einer Bitleitung für jede der Spalten, die mit ersten Polen zu der Spalte gehörenden Speicherzellen verbunden ist; und einer Wortleitung für jede der Reihen, die mit zweiten Polen der zu der Reihe gehörenden Speicherzellen verbunden ist; wobei das Verfahren folgende Schritte aufweist:

A: Anlegen einer Lesespannungsquelle an den zweiten Pol einer auszulesenden Speicherzelle;

B: Bewerten der über einen ersten Abschlußwiderstand abfallenden Spannung mit einem zum ersten Anschlußwiderstand parallelen Spannungsbewerter, wobei der erste Abschlußwiderstand und ein erster Eingang des Spannungsbewerters mit dem ersten Pol der auszulesenden Speicherzelle verbunden sind; dadurch gekennzeichnet, daß

C: die über den ersten Abschlußwiderstand abfallende Spannung auch an den Eingang eines Impedanzwandlers angelegt wird und die Spannung am Ausgang des Impedanzwandlers an diejenigen Wort- und Bitleitungen angelegt wird, welche nicht mit der auszulesenden Speicherzelle verbunden sind.

Beim erfindungsgemäßen Verfahren macht man sich somit das Prinzip des Spannungsteilers zunutze, bei dem sich auf Grund einer bekannten Lesespannung und eines bekannten Abschlußwiderstands ein definierter Spannungsabfall sowohl über den Abschlußwiderstand als auch über den Spannungsbewerter und den Impedanzwandler einstellt. Während der Spannungsbewerter eine Messung der anliegenden Spannung durchführt, um auf den Widerstandswert der auszulesenden Speicherzelle rückschließen zu können, macht der Impedanzwandler sein Ausgangssignal bei identischer Spannung mit dem Eingangssignal niederohmig und kann somit die verschiedenen Bit- und Wortleitungen mit ihren zwischengeschalteten Widerstandspeicherzellen treiben. Dadurch, daß die somit an die Pole der Speicherzellen angelegten Spannungen gleich der an der zur auszulesenden Speicherzelle angeschlossenen Bitleitungsspannung sind, kommt es auf der Bitleitung, an der die auszulesende Speicherzelle hält, zu keinem Stromfluß, außer durch die auszulesende Speicherzelle. An den anderen Speicherzellen, welche zu der Wortleitung gehören, die auch mit der auszulesenden Speicherzelle verbunden ist, kommt es hingegen zu einem Stromfluß, den der Verstärker tragen muß. Insgesamt läßt sich durch diese Anordnung die Stabilität des Auslesevorgangs und dessen Genauigkeit wesentlich erhöhen.

Daher sollte die Ausgangsspannung des Impedanzwandlers vorzugsweise gleich seiner Eingangsspannung sein. Abweichungen davon führen zu einer Verschlechterung des Meßergebnisses und beeinträchtigen damit das zuverlässige Bestimmen des Binärwerts der auszulesenden Speicherzelle.

Die sukzessive Schilderung der erfindungsgemäßen Verfahrensschritte beinhaltet keine zeitliche Abfolge. Während die Schritte nacheinander durchgeführt werden können, müssen doch für eine zuverlässige Bewertung durch den Spannungsbewerter alle durch die Schritte einzustellenden Bedingungen erst gewährleistet sein, bevor eine zuverlässige Messung möglich ist. Es ist daher aus Praktikabilitäts- sowie auch aus Geschwindigkeitsgründen bevorzugt, daß die Schritte A, B und C im wesentlichen gleichzeitig ausgeführt werden.

Das in Schritt B ausgeführte Bewerten kann beispielsweise folgende Teilschritte aufweisen:

B1: Verbinden der mit der auszulesenden Speicherzelle verbundenen Bitleitung über eine Bewerterleitung mit dem ersten Eingang des Spannungsbewerters, dem ersten Abschlußwiderstand und dem Eingang des Impedanzwandlers; und

B2: Bestimmen der am ersten Eingang anliegenden Spannung im Spannungsbewerter.

Wie bereits oben geschildert, läßt sich das erfindungsgemäße Verfahren weiter verfeinern, um die Genauigkeit der Wertebestimmung der auszulesenden Speicherzellen zu verbessern. So ist es möglich, zwei voneinander unabhängige Lesevorgänge vorzunehmen, bei denen die jeweils entstehenden Spannungen in zwei, mit Eingängen des Spannungsbewerters parallel geschalteten Kapazitäten zwischengespeichert werden. Die so zwischengespeicherten Spannungswerte können dann im Spannungsbewerter abschließend zusammen bewertet werden. Es ist jedoch auch möglich, das Verfahren dahingehend zu verbessern, daß die zwei Lesevorgänge nacheinander durchgeführt werden und ein Umschaltvorgang dazwischen durchgeführt wird. Dies hat den Vorteil, daß die Messung der Spannungen nicht so genau erfolgen muß, da mehr auf möglicherweise auftretende Unterschiede der sich ergebenden Spannungen vor und nach dem Umschaltversuch abzustellen ist. Das Verfahren weist somit einen ersten Lesevorgang auf, gefolgt von einem Umschaltversuch, der wiederum von einem zweiten Lesevorgang des Spannungswertes gefolgt ist. Eine vorzugsweise Ausführungsform dieses mehrschrittigen Verfahrens beinhaltet folgende weitere Schritte:

D: Speichern der über den ersten Abschlußwiderstand abfallenden Spannung in einer ersten und einer dritten Kapazität, die mit dem ersten Eingang des Spannungsbewerters und dem Eingang des Impedanzwandlers verbunden sind (wobei die dritte Kapazität sinnvollerweise in räumlicher Nähe zum Impedanzwandler und die erste Kapazität in räumlicher Nähe zum Spannungsbewerter angeordnet ist) ;

E: Trennen des ersten Eingangs des Spannungsbewerters und der ersten Kapazität vom ersten Abschlußwiderstand;

F: Trennen des Eingangs des Impedanzwandlers und der dritten Kapazität vom ersten Abschlußwiderstand;

G: Trennen der Lesespannungsquelle von der auszulesenden Speicherzelle;

H: Trennen des ersten Abschlußwiderstands von der auszulesenden Speicherzelle;

I: Anlegen der am Ausgang des Impedanzwandlers anliegenden Spannung an alle Wort- und Bitleitungen;

J: Anlegen einer ersten Stromquelle an die die mit dem zweiten Pol der auszulesenden Speicherzelle verbundenen Wortleitung;

K: Anlegen einer zweiten Stromquelle an die mit dem ersten Pol der auszulesenden Speicherzelle verbundene Bitleitung;

L: Trennen der ersten Stromquelle von der mit dem zweiten Pol der auszulesenden Speicherzelle verbundenen Wortleitung;

M: Trennen der zweiten Stromquelle der mit dem ersten Pol der auszulesenden Speicherzelle verbundenen Bitleitung;

N: Trennen der am Ausgang des Impedanzwandlers anliegenden Spannung vom zweiten Pol der auszulesenden Speicherzelle;

O: Trennen der am Ausgang des Impedanzwandlers anliegenden Spannung vom ersten Pol der auszulesenden Speicherzelle;

P: Verbinden der mit der auszulesenden Speicherzelle verbundenen Bitleitung über die Bewerterleitung mit dem zweiten Eingang des Spannungsbewerters, dem zweiten Abschlußwiderstand und dem Eingang des Impedanzwandlers;

Q: Anlegen der Lesespannungsquelle an den zweiten Pol der auszulesenden Speicherzelle;

R: Speichern der über einen zweiten Abschlußwiderstand abfallenden Spannung in einer zum zweiten Abschlußwiderstand parallelen zweiten Kapazität, wobei der zweite Abschlußwiderstand die zweite Kapazität und ein zweiter Eingang des Spannungsbewerters mit dem ersten Pol der auszulesenden Speicherzelle verbunden sind;

S: Vergleichen der in der ersten und in der zweiten Kapazität gespeicherten Spannung im Spannungsbewerter.

Die oben angegebenen Schritte des erfindungsgemäßen Verfahrens führen zu einer klaren Verbesserung der Bewertungsqualität. Auch hier gilt, daß trotz der Aneinanderreihung der verschiedenen Schritte nicht alle Schritte nacheinander ablaufen müssen. Vielmehr ist es möglich, verschiedene Schritte auch gleichzeitig oder im wesentlichen gleichzeitig durchzuführen. So ist es bevorzugt, die folgenden Schritte im wesentlichen gleichzeitig auszuführen:

A-D;
E, F;
G, H;
I;
J, K;
L, M;
N-P;
Q, S.

Im folgenden soll die Erfindung an Hand eines Ausführungsbeispiels näher erläutert werden, wobei auf die beigefügten Zeichnungen Bezug genommen wird, in denen folgendes dargestellt ist:

Figur 1 zeigt eine Ausführungsform eines erfindungsgemäßen magnetoresistiven Speichers während eines ersten Lesevorgangs; Figur 2 zeigt die gleiche Ausführungsform des erfindungsgemäßen magnetoresistiven Speichers während eines Umschaltversuchs; und
Figur 3 zeigt die gleiche Ausführungsform des erfindungsgemäßen magnetoresistiven Speichers während eines zweiten Lesevorgangs.

Wie oben beschrieben ist es möglich, die Erfindung unter Verwendung eines einfachen Bewerters mit einem Eingang und eines einfachen Bewertungsverfahrens ausgeführt werden. Die im folgenden näher beschriebene doppelte Lesemethode erlaubt eine zuverlässige Bewertung trotz der erwarteten großen lokalen Zellwiderstandsvariationen.
In einzelnen sind dies folgende Schritte:

1. Auslesen des Zell-Zustandes und Speicherung der Information,
2. anschließend Schaltversuch in eine bestimmte Richtung,
3. weiteres Auslesen des Zell-Zustandes und Speicherung der Information,
4. Vergleich der Ergebnisse und Bewertung.

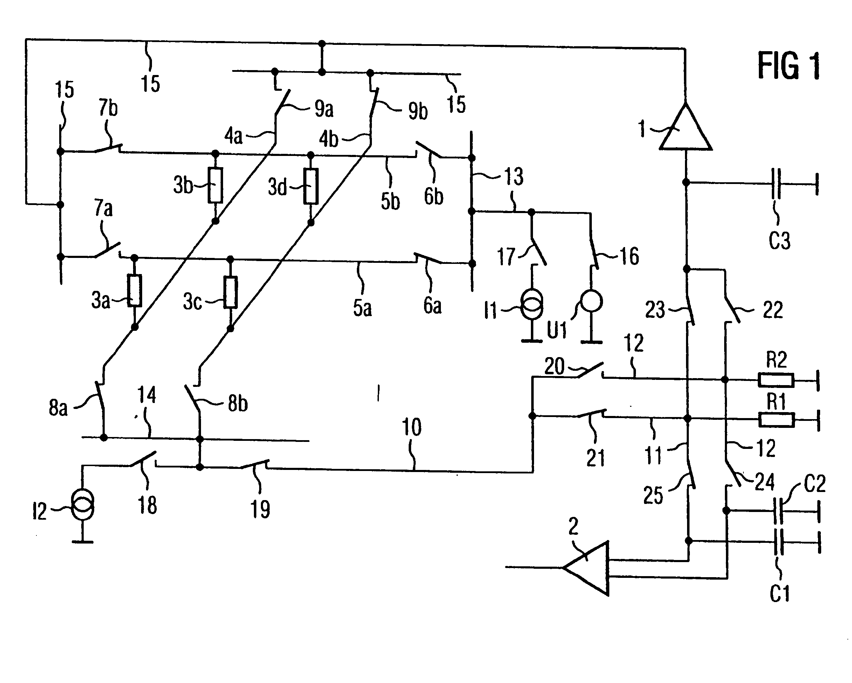

*Erster Bewertungsvorgang* (Fig. 1): Vorgeschlagen wird eine Matrix, bestehend aus m Wortleitungen 5a, 5b und n Bitleitungen 4a, 4b, bei der die selektierte Wortleitung 5a mittels einer Spannungsquelle U1 über einen Leseverteiler 13 und ein Schaltelements 6a auf ein vorgegebenes Potential (z.B. 1.2 V) gelegt wird. Die selektierte Bitleitung 4a wird mittels eines Abschlußwiderstands R1 über eine Bewerterleitung 10, einen Bewerterverteiler 14 und Schaltelemente 8a, 8b, 19, 21 gegen GND-Potential verbunden, so dass sich die resultierende BL-(Bitleitungs)-Spannung über dem Spannungsteiler, bestehend aus dem Zellwiderstand der auszulesenden Speicherzelle 3a und R1 ergibt. So entsteht ein Spannungsabfall über den zu charakterisierenden Zellwiderstand, dessen Wert durch die Größe des Zellwiderstands bestimmt wird (bei einem Zellwiderstand von $10^5$ $\Omega$ und einem Strom von 5 $\mu$A entsteht ein Spannungsabfall von 0.5 V und damit ein Pegel von ca. 0.7 V an der ausgewählten Bitleitung 4a). Die genaue Bitleitungsspannung wird zwischengespeichert in einem ersten Kondensator C1, der sich im Bewertungsbereich befindet.
Falls erfindungsgemäß nur ein Bewertungsvorgang durchgeführt werden soll, wird der erste Kondensator C1 zum Zwischenspeichern der Spannung nicht benötigt. In diesem Fall kann die Spannung sofort mittels eines Spannungsbewerters 2, der an die Bewerterleitung 10 angeschlossen und ansonsten mit der ersten Kapazität C1 parallel geschaltet ist (d.h. beide liegen an denselben Potentialen), bestimmt werden.
Falls jedoch das erfindungsgemäße Verfahren mit zwei Lesevorgängen verwendet werden soll, wird der gleiche Spannungswert noch in einem dritten Kondensator C3 zwischengespeichert, da diese Spannung für den nachfolgenden Schreibvorgang benötigt wird. Sämtliche nicht angesprochenen Bit- und Wortleitungen 4b, 5b werden mit Hilfe eines Impedanzwandlers 1 (V=1 Verstärker) über einen Spannungsverteiler 15 auf der Spannung der angesprochenen Bitleitung 4a gehalten (ca. 0.7 V). So entstehen im Prinzip nicht erwünschte Zellströme durch nicht angesprochene Speicherzellen 3b, 3c, 3d über nicht angesprochene Zellen an der angesprochenen Wortleitung 5a. Diese Ströme laufen auf nicht angesprochene Bitleitungen (in Fig.1 Speicherzelle 3c, es entsteht je ein Zellstrom von ca. 5 $\mu$A pro Bitleitung). Sie müssen durch den V=1 Verstärker 1 getragen werden. Bei 200 Zellen pro Wortleitung handelt es sich um einen Strom von 1 mA, der über 10 ns fließt und eine Energie von 12 pJ dissipiert. Dieser Stromwert liegt an der Grenze oberhalb deren Zellen progammiert werden können. Arrays mit einer wesentlich größeren Anzahl von Zellen pro Wortleitung sind deshalb nicht möglich. Dazu kommen noch Ladeströme von der Bitleitungsspannung, die sich entsprechend dem genauen Wert des Zellwiderstandes um ca. 10-20 % ändern kann. Die Bestimmung des dazu nötigen Energieverbrauchs kann in Simulationsuntersuchungen jeweils ermittelt werden.

Der Gesamtwert des Energieverbrauchs von 12 pJ kann mit dem eines Einzelbitzugriffs eines DRAM verglichen werden, der eine Energie von ca. 200 pJ benötigt. Für diesen Fall liegt somit der Energieverbrauch des DRAM um eine Größenordnung über der des MRAM. Andere Zugriffsformen sind denkbar und somit auch andere Ergebnisse. Es zeigt sich, dass für das MRAM zum gegenwärtigen Zeitpunkt keine Probleme bzgl. Leistungsverbrauch des Lesevorgangs gesehen werden können.

Die angegebene Spannung von ca. 0.7 V ist auch die Ruhespannung der Anordnung. Wenn ein Lesezugriff erfolgt, wird nur eine Wortleitung umgeladen. So wird Leistung gespart.

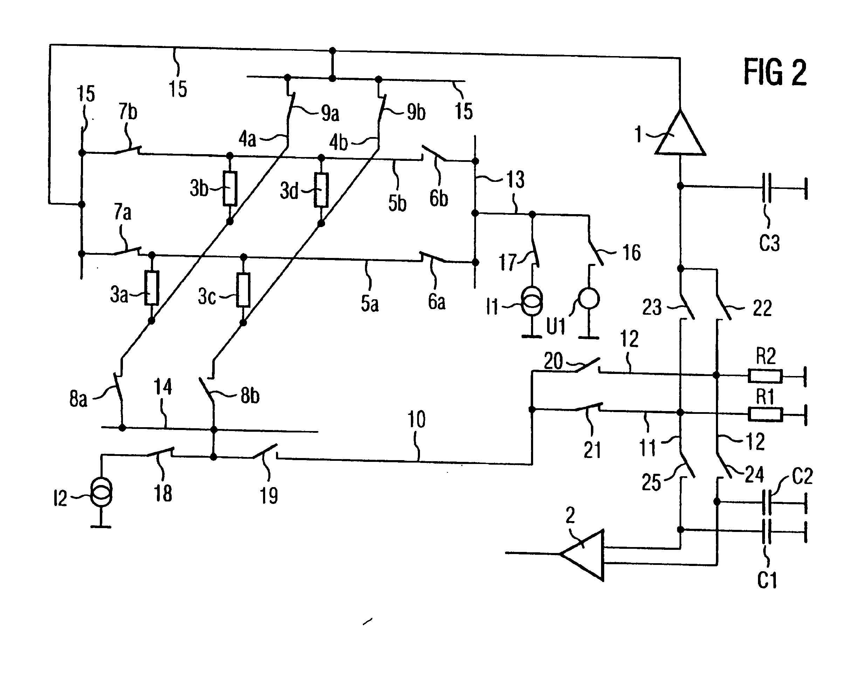

*Schaltversuch in eine bestimmte Richtung* (Fig. 2; dieser Vorgang entspricht im wesentlichen auch dem Programmiervorgang): Von der ersten Bewertung ist der Spannungswert in den Kapazitäten C1 und C3 zwischengespeichert. Das Potential auf C3 wird nun als Referenzspannung verwendet und gepuffert über den V=1 Verstärker 1, der somit als Spannungsquelle dient, in sämtliche Wort- und Bitleitungen 4a, 4b, 5a, 5b eingeprägt, indem alle den Spannungsverteiler 15 mit den Wort- und Bitleitungen verbindenden Schaltelemente 7a, 7b, 9a, 9b geschlossen werden. Auf diese Weise wird Leistung gespart, da das Zellenfeld gegenüber dem 1. Lesevorgang im wesentlichen auf unverändertem Potential bleibt. Zusätzlich wird in die ausgewählte Bit- und Wortleitung 4a, 5a jeweils ein Strom über die Schreibstromquellen I1 und I2 eingeprägt, der die auszulesende Speicherzelle 3a umprogrammiert, wenn der Zustand der Zelle 3a und die Stromrichtunen dieses erlauben. Das Einprägen des Stromes über die Stromquellen I1 und I2 erfolgt durch Aufschalten der Stromquellen mittels der Schaltelemente 17 und 18, während zu diesem Zeitpunkt sowohl der Bewerterkomplex mittels Schaltelement 19 als auch die Spannungsquelle U1 mittels des Schaltelements 16 von der Speicherzellenanordnung getrennt sind. Die Stromstärken der Stromquellen I1 und I2 liegen jeweils bei ca. 1 mA. Die Ströme werden von den Schreibstromquellen I1 und I2 in die Wortleitung 5a und die Bitleitung 4a eingeprägt und vom Impedanzwandler 1, der als Spannungsquelle arbeitet, aufgenommen.

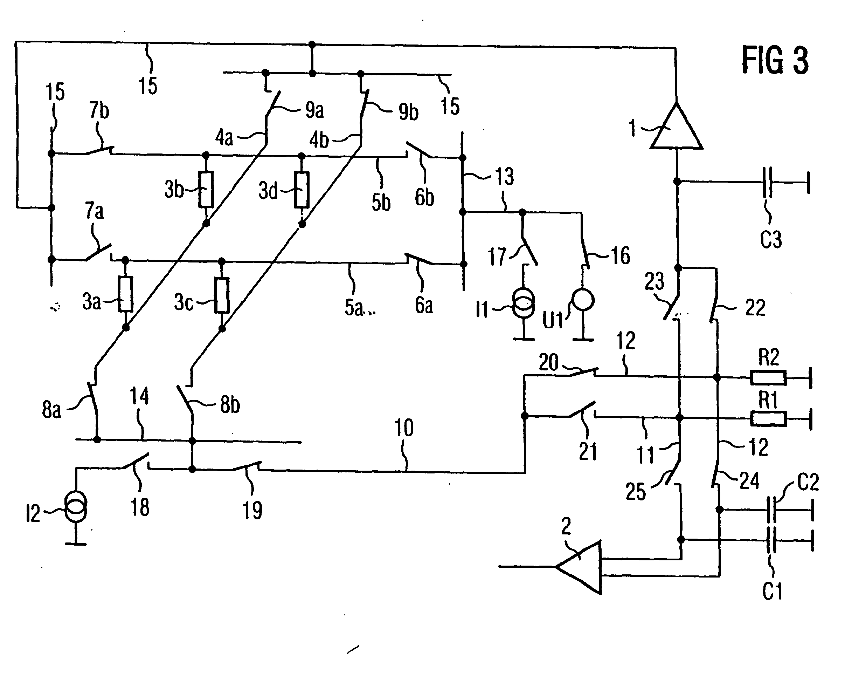

*Zweiter Bewertungsvorgang* (Fig. 3) : Von der ersten Bewertung ist weiterhin der zugehörige Spannungswert in der ersten Kapazität C1 gespeichert. Nun erfolgt eine Bewertung analog zur ersten Bewertung, allerdings wird der entsprechende Spannungswert nun in einer zweiten Kapazität C2 gespeichert. Zu diesem Zweck ist die Bewerterleitung in eine Anschlußleitung 10 und zwei Bewerterpfade 11 und 12, welche über Schaltelemente 20, 21 mit der Anschlußleitung 10 einzeln verbindbar sind, gegliedert. Jeder Bewerterpfad enthält einen Abschlußwiderstand R1, R2 und eine Kapazität C1, C2, die über Schaltelemente 24, 25 von ihrem Abschlußwiderstand trennbar sind. Durch diese Anordnung, zu der auch noch Abzweigungen zum Impedanzwandler mit Schaltelementen 22, 23 gehören, sind zwei voneinander unabhängige Meßstränge realisiert, welche zwei unabhängige Messungen erlauben. Anschließend trifft der Spannungsbewerter 2 die Entscheidung, indem er die in den Kapazitäten C1 und C2 gespeicherten Spannungen vergleicht.

Allerdings sollte vorzugsweise eine Unsymmetrie in das System eingebaut werden, da der Programmierversuch entweder erfolgreich sein kann oder zu keiner Veränderung des Zellinhalts der auszulesenden Speicherzelle 3a führt. Die Unsymmetrie kann in den beiden Abschlußwiderständen R1, R2 oder durch unsymmetrischen Aufbau des Spannungsbewerters 2 realisiert werden. Das Ergebnis der Bewertung kann anschließend am Ausgang des Spannungsbewerters 2 abgegriffen werden.

Im folgenden soll die Zugriffszeit der erfindungsgemäßen Schaltung abgeschätzt werden. Für einen Zellwiderstand von $10^5$ Ω und eine Zellkapazität von 10 fF ergibt sich eine Ladezeitkonstante für die angesprochene Zelle beim Lesen von 1 ns. Das System hat eine zweite Zeitkonstante, nämlich die zum Laden einer Leitung. Wenn für die Spannungsquelle U1 ein Innenwiderstand von 100 Ω angenommen wird, ergibt sich bei einer Leitung mit 10 pF (1000 Zellen) ebenfalls eine Zeitkonstante von 1 ns. Beide Zeitkonstanten liegen in einem günstigen Bereich. Eine Bewertungszeit grob vergleichbar mit dem DRAM erscheint machbar.

Weiterhin sollen die Eigenschaften des Impedanzwandlers 1 (V=1 Verstärkers) abgeschätzt werden. Ein Offset des Impedanzwandlers 1 führt zu einer Verschiebung der Spannung auf der Bitleitung, da Ströme durch nichtangesprochene Zellen der angesprochenen Bitleitung auftreten. Da wir von N = 1000 Zellen pro Bitleitung ausgehen, ist dieser Effekt relativ stark. Die Offsetspannung Δ greift voll durch auf die Wortleitungsspannung $V_{WL}$. Allerdings tritt sie in beiden Bewertungen gleich auf, was zu einer Teilkompensation führt. Für das Lesesignal S ergibt sich

$$S = f(R)(N\Delta - V_{WL})$$

f(R) ist eine Funktion verschiedener Widerstände und liegt für die gegebenen Verhältnisse bei 0.02. Für einen Wert von $V_{WL}$ = 1.2 V ergibt sich eine Obergrenze für Δ von 1.2 mV. Verstärker mit einem Offset von ca. 1 mV sind heute gut machbar und haben für eine Ausregelzeit von einigen ns und einen Ausgangsstrom von einigen mA einen Stromverbrauch in der Gegend von einigen mA.

Der Spannungsunterschied zwischen einem Datum "0" und "1" kann unter den oben angenommenen Bedingungen bei beispielsweise 24 mV liegen, jedoch auch einen anderen, sich aus der Schaltung ergebenden Wert aufweisen. Ein Wert von 24 mV ist vernünftig auswertbar. Der Vorteil des MRAM besteht darin, dass die Auswertungsschaltung nicht den Platzbeschränkungen des Pitchbereiches unterliegt, da sie problemlos außerhalb des Zellenfeldes plaziert werden kann.

**Bezugszeichenliste**

C1 Erste Kapazität
C2 Zweite Kapazität
C3 Dritte Kapazität
R1 Erster Abschlußwiderstand
R2 Zweiter Abschlußwiderstand
U1 Lesespannungsquelle
I1 Erste Schreibstromquelle
I2 Zweite Schreibstromquelle
1 Impedanzwandler
2 Spannungsbewerter
3a, 3b, 3c, 3d magnetoresistive Speicherzellen
4a, 4b Bitleitungen
5a, 5b Wortleitungen
6a, 6b Schaltelemente zur Verbindung der Wortleitungen mit
Lesespannungsquelle, Schreibstromquelle
7a, 7b Schaltelemente zur Verbindung der Wortleitungen mit Impedanzwandlerausgang
8a, 8b Schaltelemente zur Verbindung der Bitleitungen mit Spannungsbewerter, Schreibstromquelle
9a, 9b Schaltelemente zur Verbindung der Bitleitungen mit Impedanzwandlerausgang
10 Bewerterleitung/Anschlußleitung
11 Erster Bewerterpfad
12 Zweiter Bewerterpfad
13 Leseverteiler
14 Bewerterverteiler
15 Impedanzverteiler
16 Schaltelement zur Verbindung von Lesespannungsquelle mit Leseverteiler
17 Schaltelement zur Verbindung von erster Schreibstromquelle mit Leseverteiler
18 Schaltelement zur Verbindung von zweiter Schreibstromquelle mit Bewerterverteiler
19 Schaltelement zur Verbindung von Bewerterleitung mit Leseverteiler
20 Schaltelement zur Verbindung von zweitem Bewerterpfad mit Anschlußleitung
21 Schaltelement zur Verbindung von erstem Bewerterpfad mit Anschlußleitung

22 Schaltelement zur Verbindung von zweitem Bewerterpfad mit Impedanzwandler und dritter Kapazität
23 Schaltelement zur Verbindung von erstem Bewerterpfad mit Anschlußleitung
24 Schaltelement zur Verbindung von zweitem Bewerterpfad mit Spannungsbewerter und zweiter Kapazität
25 Schaltelement zur Verbindung von erstem Bewerterpfad mit Spannungsbewerter und erster Kapazität

**Patentansprüche**

1. Magnetoresistiver Speicher mit
   einer Anordnung von in einer Mehrzahl von Reihen und/oder einer Mehrzahl von Spalten angeordneten magnetoresistiven Speicherzellen (3a,3b,3c,3d);
   einer Bitleitung (4a, 4b) für jede der Spalten, die mit ersten Polen der zu der Spalte gehörenden Speicherzellen (3a, 3b,3c,3d) verbunden ist;
   einer Wortleitung (5a,5b) für jede der Reihen, die mit zweiten Polen der zu der Reihe gehörenden Speicherzellen (3a,3b, 3c,3d) verbunden ist;
   einer Lesespannungsquelle (U1), die mit ersten Enden der Wortleitungen durch Schaltelemente (6a, 6b, 16) einzeln verbindbar ist;
   einem Spannungsbewerter (2), dessen zumindest ein Eingang über eine Bewertungsleitung (10, 11, 12) mit ersten Enden der Bitleitungen (4a,4b) durch Schaltelemente (8a, 8b) einzeln verbindbar ist, wobei von der Bewertungsleitung (10, 11,12) ein erster Abschlusswiderstand (R1) abzweigt; und
   einem Impedanzwandler (1), dessen Eingang mit der Bewertungsleitung (10, 11, 12) verbunden ist und dessen Ausgang mit zweiten Enden der Bitleitungen (4a, 4b) und Wortleitungen (5a, 5b) **durch** Schaltelemente (7a, 7b, 9a, 9b) einzeln verbindbar ist.

2. Magnetoresistiver Speicher nach Anspruch 1, **dadurch gekennzeihnet**,
   dass die Bewertungsleitung (10, 11, 12) eine Anschlussleitung (10) zur Verbindung mit den Bitleitungen (4a, 4b) und zwei Bewertungspfade (11, 12), die durch Schaltelemente (20, 21) mit der Anschlussleitung (10) einzeln verbindbar sind, aufweist;
   wobei von den Bewertungspfaden (11, 12) je ein Abschlusswiderstand (R1, R2) abzweigt;
   wobei jeder der beiden Bewertungspfade (11, 12) durch ein Schaltelement (24, 25) mit einem Eingang des Spannungsbewerters (2) und einer dazu parallelen Kapazität (C1, C2) verbindbar ist;
   und jeder der beiden Bewertungspfade (11, 12) durch ein Schaltelement (22, 23) mit dem Eingang des Impedanzwandlers (1) und einer zu dem Eingang parallelen Kapazität (C3) verbindbar ist.

3. Magnetoresistiver Speicher nach Anspruch 1 oder 2, **dadurch gekennzeichnet, dass** er weiterhin aufweist:

   eine erste Schreibstromquelle (I1), die mit den ersten Enden der Wortleitungen (5a, 5b) durch Schaltelemente (6a, 6b, 17) einzeln verbindbar ist; und eine zweite Schreibstromquelle (I2), die mit den ersten Enden der Bitleitungen (4a, 4b) durch Schaltelemente (8a, 8b, 18) einzeln verbindbar ist.

4. Magnetoresistiver Speicher nach einem der Ansprüche 1 bis 3, **dadurch gekennzeichnet, dass** die Verbindung der Bitleitungen (4a, 4b) mit der Bewertungsleitung (10, 11, 12) durch einen Bewerterverteiler (14) mit einem Schaltelement (8a, 8b) für jede der Bitleitungen (4a, 4b) erfolgt.

5. Magnetoresistiver Speicher nach Anspruch 4, **dadurch gekennzeichnet, dass** die Verbindung der Bitleitungen (4a, 4b) mit der zweiten Schreibstromquelle (I2) ebenfalls durch den Bewerterverteiler (14) erfolgt, wobei zweite Schreibstromquelle (I2) und Bewertungsleitung (10, 11, 12) durch Schaltelemente (18, 19) mit dem Bewerterverteiler (14) verbindbar sind.

6. Magnetoresistiver Speicher nach einem der Ansprüche 1 bis 5, **dadurch gekennzeichnet, dass** die Verbindung des Ausgangs des Impedanzwandlers (1) mit den Bit- und Wortleitungen (4a, 4b, 5a, 5b) durch einem Pufferverteiler (15) mit einem Schaltelement (7a, 7b, 9a, 9b) für jede Bit- und Wortleitung (4a, 4b, 5a, 5b) erfolgt.

7. Magnetoresistiver Speicher nach einem der Ansprüche 1 bis 6, **dadurch gekennzeichnet, dass** die Verbindung der Lesespannungsquelle (U1) mit den Wortleitungen (5a, 5b) durch einen Leseverteiler (13) mit einem Schaltelement (6a, 6b) für jede Wortleitung (5a, 5b) erfolgt.

8. Magnetoresistiver Speicher nach Anspruch 7, **dadurch gekennzeichnet, dass** die Verbindung der ersten Schreibstromquelle (I1) mit den Wortleitungen (5a, 5b) ebenfalls durch den Leseverteiler (13) erfolgt, wobei erste Schreibstromquelle (I1) und Lesespannungsquelle (U1) durch Schaltelemente (16, 17) mit dem Leseverteiler (13) verbindbar sind.

9. Magnetoresistiver Speicher nach einem der Ansprüche 1 bis 8,

**dadurch gekennzeichnet, dass** die Schaltelemente Transistoren sind.

10. Verfahren zum Auslesen von Speicherzellen in einem magnetoresistiven Speicher mit einer Anordnung von in einer Mehrzahl von Reihen und/oder einer Mehrzahl von Spalten angeordneten magnetoresistiven Speicherzellen (3a, 3b, 3c, 3d); einer Bitleitung (4a, 4b) für jede der Spalten, die mit ersten Polen der zu der Spalte gehörenden Speicherzellen (3a, 3b; 3c, 3d) verbunden ist; und einer Wortleitung (5a, 5b) für jede der Reihen, die mit zweiten Polen der zu der Reihe gehörenden Speicherzellen (3a, 3c; 3b, 3d) verbunden ist ; wobei das Verfahren folgende Schritte aufweist:

    A: Anlegen einer Lesespannungsquelle (U1) an den zweiten Pol einer auszulesenden Speicherzelle (3a);
    B: Bewerten der über einen ersten Abschlusswiderstand (R1) abfallenden Spannung mit einem Spannungsbewerter (2), wobei der erste Abschlusswiderstand (R1) und ein erster Eingang des Spannungsbewerters (2) mit dem ersten Pol der auszulesenden Speicherzelle (3a) verbunden sind; und
    C: Anlegen der über dem ersten Abschlusswiderstand (R1) abfallenden Spannung auch an den Eingang eines Impedanzwandlers (1) und Anlegen der Spannung am Ausgang des Impedanzwandlers (1) an diejenigen Wort- und Bitleitungen (7b, 9b), welche nicht mit der auszulesenden Speicherzelle (3a) verbunden sind.

11. Verfahren nach Anspruch 10, **dadurch gekennzeichnet, dass** die Ausgangsspannung des Impedanzwandlers (1) gleich seiner Eingangsspannung ist.

12. Verfahren nach Anspruch 10 oder 11, **dadurch gekennzeichnet, dass** die Schritte A, B, und C im Wesentlichen gleichzeitig ausgeführt werden.

13. Verfahren nach einem der Ansprüche 10 bis 12, **dadurch gekennzeichnet, dass** das Bewerten B folgende Schritte aufweist:

    B1: Verbinden der mit der auszulesenden Speicherzelle (3a) verbundenen Bitleitung (4a) über eine Bewertungsleitung (10, 11, 12) mit dem ersten Eingang des Spannungsbewerters (2), dem ersten Abschlusswiderstand (R1) und dem Eingang des Impedanzwandlers (1); und
    B2: Bestimmen der am ersten Eingang anliegenden Spannung im Spannungsbewerter (2).

14. Verfahren nach einem der Ansprüche 10 bis 13,

**dadurch gekennzeichnet,**

**dass** es folgende weitere Schritte aufweist:

D: Speichern der über den ersten Abschlusswiderstand (R1) abfallenden Spannung in einer ersten und einer dritten Kapazität (C1, C3), die mit dem ersten Eingang des Spannungsbewerters (2) und dem Eingang des Impedanzwandlers (1) verbunden sind;

E: Trennen des ersten Eingangs des Spannungsbewerters (2) und der ersten Kapazität (C1) vom ersten Abschlusswiderstand (R1);

F: Trennen des Eingangs des Impedanzwandlers und der dritten Kapazität vom ersten Abschlusswiderstand;

G: Trennen der Lesespannungsquelle (U1) von der auszulesenden Speicherzelle (3a);

H: Trennen des ersten Abschlusswiderstands (R1) von der auszulesenden Speicherzelle (3a);

I: Anlegen der am Ausgang des Impedanzwandlers (1) anliegenden Spannung an alle Wort- und Bitleitungen (4a, 4b, 5a, 5b);

J: Anlegen einer ersten Stromquelle (I1) an die mit dem zweiten Pol der auszulesenden Speicherzelle (3a) verbundenen Wortleitung;

K: Anlegen einer zweiten Stromquelle (I2) an die mit dem ersten Pol der auszulesenden Speicherzelle (3a) verbundene Bitleitung;

L: Trennen der ersten Stromquelle (I1) von der mit dem zweiten Pol der auszulesenden Speicherzelle (3a) verbundenen Wortleitung;

M: Trennen der zweiten Stromquelle (I2) von der mit dem ersten Pol der auszulesenden Speicherzelle (3a) verbundenen Bitleitung;

N: Trennen der am Ausgang des Impedanzwandlers (1) anliegenden Spannung vom zweiten Pol der auszulesenden Speicherzelle (3a);

O: Trennen der am Ausgang des Impedanzwandlers (1) anliegenden Spannung vom ersten Pol der auszulesenden Speicherzelle (3a);

P: Verbinden der mit der auszulesenden Speicherzelle verbundenen Bitleitung über die Bewertungsleitung (10, 11, 12) mit dem zweiten Eingang des Spannungsbewerters, dem zweiten Abschlusswiderstand (R2) und dem Eingang des Impedanzwandlers;

Q: Anlegen der Lesespannungsquelle (U1) an den zweiten Pol der auszulesenden Speicherzelle (3a);

R: Speichern der über den zweiten Abschlusswiderstand (R2) abfallenden Spannung in einer zum zweiten Abschlusswiderstand (R2) parallelen zweiten Kapazität (C2), wobei der zweite Abschlusswiderstand (R2), die zweite Kapazität (C2) und ein zweiter Eingang des Spannungsbewerters (2) mit dem ersten Pol der auszulesenden Speicherzelle (3a) verbunden sind;

S: Vergleichen der in der ersten und der zweiten Kapazität (C1, C2) gespeicherten Spannung im Spannungsbewerter (2).

15. Verfahren nach Anspruch 14,
**dadurch gekennzeichnet,**
**dass** die Schritte A, B, C, und D im Wesentlichen gleichzeitig ausgeführt werden.

16. Verfahren nach Anspruch 14 oder 15,
**dadurch gekennzeichnet,**
**dass** die Schritte E und F im Wesentlichen gleichzeitig ausgeführt werden.

17. Verfahren nach einem der Ansprüche 14 bis 16,
**dadurch gekennzeichnet,**
**dass** die Schritte G und H im Wesentlichen gleichzeitig ausgeführt werden.

18. Verfahren nach einem der Ansprüche 14 bis 17,
**dadurch gekennzeichnet,**
**dass** die Schritte J und K im Wesentlichen gleichzeitig ausgeführt werden.

19. Verfahren nach einem der Ansprüche 14 bis 18,
**dadurch gekennzeichnet,**
**dass** die Schritte L und M im Wesentlichen gleichzeitig ausgeführt werden.

20. Verfahren nach einem der Ansprüche 14 bis 19,
**dadurch gekennzeichnet,**
**dass** die Schritte N, O und P im Wesentlichen gleichzeitig ausgeführt werden.

21. Verfahren nach einem der Ansprüche 14 bis 20,
**dadurch gekennzeichnet,**
**dass** die Schritte Q und S im Wesentlichen gleichzeitig ausgeführt werden.

**Claims**

1. Magnetoresistive memory having
an arrangement of magnetoresistive memory cells (3a, 3b, 3c, 3d) which are arranged in a plurality of rows and/or a plurality of columns;
a bit line (4a, 4b) for each of the columns, which is connected to first poles of the memory cells (3a, 3b, 3c, 3d) belonging to the column;
a word line (5a, 5b) for each of the rows, which is connected to second poles of the memory cells (3a, 3b, 3c, 3d) belonging to the row;
a read voltage source (U1) which is individually connectable to first ends of the word lines by means of switching elements (6a, 6b, 16);
a voltage evaluator (2) whose at least one input is individually connectable via an evaluation line (10, 11, 12) to first ends of the bit lines (4a, 4b) by means of switching elements (8a, 8b), wherein a first terminating resistor (R1) branches off from the evaluation line (10, 11, 12); and

an impedance converter (1), whose input is connected to the evaluation line (10, 11, 12) and whose output is individually connectable to second ends of the bit lines (4a, 4b) and word lines (5a, 5b) by means of switching elements (7a, 7b, 9a, 9b).

2. Magnetoresistive memory according to Claim 1, **characterized**

   **in that** the evaluation line (10, 11, 12) has a connecting line (10) for connection to the bit lines (4a, 4b), and has two evaluation paths (11, 12) which are individually connectable to the connecting line (10) by means of switching elements (20, 21);

   wherein a respective terminating resistor (R1, R2) branches off from the evaluation paths (11, 12);

   wherein each of the two evaluation paths (11, 12) is connectable by means of a switching element (24, 25) to one input of the voltage evaluator (2) and to a capacitance (C1, C2) in parallel with it;

   and each of the two evaluation paths (11, 12) is connectable by means of a switching element (22, 23) to the input of the impedance converter (1) and to a capacitance (C3) in parallel with the input.

3. Magnetoresistive memory according to Claim 1 or 2, **characterized**

   **in that** the memory additionally has:

   a first write current source (I1), which is individually connectable to the first ends of the word lines (5a, 5b) by means of switching elements (6a, 6b, 17); and

   a second write current source (I2), which is individually connectable to the first ends of the bit lines (4a, 4b) by means of switching elements (8a, 8b, 18).

4. Magnetoresistive memory according to one of Claims 1 to 3, **characterized**

   **in that** the bit lines (4a, 4b) are connected to the evaluation line (10, 11, 12) by means of an evaluator distributor (14) with a switching element (8a, 8b) for each of the bit lines (4a, 4b).

5. Magnetoresistive memory according to Claim 4, **characterized**

   **in that** the bit lines (4a, 4b) are likewise connected to the second write current source (I2) by means of the evaluator distributor (14), wherein the second write current source (I2) and the evaluation line (10, 11, 12) are connectable to the evaluator distributor (14) by means of switching elements (18, 19).

6. Magnetoresistive memory according to one of Claims 1 to 5,

**characterized**

**in that** the output of the impedance converter (1) is connected to the bit and word lines (4a, 4b, 5a, 5b) by means of a buffer distributor (15) with a switching element (7a, 7b, 9a, 9b) for each bit and word line (4a, 4b, 5a, 5b).

7. Magnetoresistive memory according to one of Claims 1 to 6,

   **characterized**

   **in that** the read voltage source (U1) is connected to the word lines (5a, 5b) by means of a read distributor (13) with a switching element (6a, 6b) for each word line (5a, 5b).

8. Magnetoresistive memory according to Claim 7, **characterized**

   **in that** the first write current source (11) is likewise connected to the word lines (5a, 5b) by means of the read distributor (13), wherein the first write current source (11) and the read voltage source (U1) are connectable to the read distributor (13) by means of switching elements (16, 17).

9. Magnetoresistive memory according to one of Claims 1 to 8,

   **characterized**

   **in that** the switching elements are transistors.

10. Method for reading memory cells in a magnetoresistive memory having

    an arrangement of magnetoresistive memory cells (3a, 3b, 3c, 3d) arranged in a plurality of rows and/or a plurality of columns; a bit line (4a, 4b) for each of the columns, the bit line being connected to first poles of the memory cells (3a, 3b; 3c, 3d) belonging to the column; and a word line (5a, 5b) for each of the rows, the word line being connected to second poles of the memory cells (3a, 3c; 3b, 3d) belonging to the row; the method comprising the following steps:

    A: connecting a read voltage source (U1) to the second pole of a memory cell (3a) to be read;
    B: evaluating the voltage, which is dropped across a first terminating resistor (R1), with a voltage evaluator (2), with the first terminating resistor (R1) and a first input of the voltage evaluator (2) being connected to the first pole of the memory cell (3a) to be read; and
    C: connecting the voltage, which is dropped across the first terminating resistor (R1), also to the input of an impedance converter (1), and connecting the voltage at the output of the impedance converter (1) to the word lines and bit lines (7b, 9b) not connected to the memory cell (3a) to be read.

11. Method according to Claim 10,

**characterized**
**in that** the voltage at the output of the impedance converter (1) is equal to the voltage at the input of the impedance converter.

12. Method according to Claim 10 or 11,
**characterized**
**in that** the steps A, B and C are performed substantially simultaneously.

13. Method according to one of Claims 10 to 12,
**characterized**
**in that** the evaluation B includes the following steps:

B1: connecting the bit line (4a), which is connected to the memory cell (3a) to be read, to the first input of the voltage evaluator (2), the first terminating resistor (R1), and the input of the impedance converter (1), by way of an evaluation line (10, 11, 12); and
B2: determining the voltage at the first input in the voltage evaluator (2).

14. Method according to one of Claims 10 to 13,
**characterized**
**in that** it comprises the following additional steps:

D: storing the voltage which is dropped across the first terminating resistor (R1) in a first and a third capacitor (C1, C3) connected to the first input of the voltage evaluator (2) and the input of the impedance converter (1);
E: disconnecting the first input of the voltage evaluator (2) and the first capacitor (C1) from the first terminating resistor (R1);
F: disconnecting the input of the impedance converter and the third capacitor from the first terminating resistor;
G: disconnecting the read voltage source (U1) from the memory cell (3a) to be read;
H: disconnecting the first terminating resistor (R1) from the memory cell (3a) to be read;
I: connecting the voltage at the output of the impedance converter (1) to all of the word lines and the bit lines (4a, 4b, 5a, 5b);
J: connecting a first current source (11) to the word line connected to the second pole of the memory cell (3a) to be read;
K: connecting a second current source (12) to the bit line connected to the first pole of the memory cell (3a) to be read;
L: disconnecting the first current source (I2) from the word line connected to the second pole of the memory cell (3a) to be read;
M: disconnecting the second current source (I2) from the bit line connected to the first pole of the memory cell (3a) to be read;
N: disconnecting the voltage at the output of the impedance converter (1) from the second pole of the memory cell (3a) to be read;
O: disconnecting the voltage at the output of the impedance converter (1) from the first pole of the memory cell (3a) to be read;
P: connecting the bit line, which is connected to the memory cell to be read, to the second input of the voltage evaluator, the second terminating resistor (R2), and the input of the impedance converter, by way of the evaluation line (10, 11, 12);
Q: connecting the read voltage source (U1) to the second pole of the memory cell (3a) to be read;
R: storing the voltage which is dropped across the second terminating resistor (R2) in a second capacitor (C2) in parallel to the second terminating resistor (R2), wherein the second terminating resistor (R2), the second capacitor (C2), and a second input of the voltage evaluator (2) are connected to the first pole of the memory cell (3a) to be read; and
S: comparing the voltage stored in the first and second capacitors (C1, C2) in the voltage evaluator (2).

15. Method according to Claim 14,
**characterized**
**in that** steps A, B, C and D are performed substantially simultaneously.

16. Method according to Claim 14 or 15,
**characterized**
**in that** steps E and F are performed substantially simultaneously.

17. Method according to one of Claims 14 to 16,
**characterized**
**in that** steps G and H are performed substantially simultaneously.

18. Method according to one of Claims 14 to 17,
**characterized**
**in that** steps J and K are performed substantially simultaneously.

19. Method according to one of Claims 14 to 18,
**characterized**
**in that** steps L and M are performed substantially simultaneously.

20. Method according to one of Claims 14 to 19,
**characterized**
**in that** steps N, O and P are performed substantially simultaneously.

21. Method according to one of Claims 14 to 20,
**characterized**

**in that** steps Q and S are performed substantially simultaneously.

**Revendications**

1. Mémoire magnétorésistive comprenant une configuration de cellules (3a, 3b, 3c, 3d) de mémoire magnétorésistive disposée suivant une multiplicité de rangées et/ou une multiplicité de colonnes ; une ligne (4a, 4b) de bits pour chacune des colonnes, qui est reliée à de premiers pôles des cellules (3a, 3b, 3c, 3d) de mémoire appartenant à la colonne ; une ligne (5a, 5b) de mots pour chacune des rangées, qui est reliée à des deuxièmes pôles des cellules (3a, 3b, 3c, 3d) de mémoire appartenant à la rangée ; une source (U1) de tension de lecture, qui peut être reliée individuellement à des premières extrémités des lignes de mots par des éléments (6a, 6b, 16) de commutation ; un évaluateur (2) de tension, dont au moins une entrée peut être reliée individuellement par une ligne (10, 11, 12) d'évaluation à de premières extrémités des lignes (4a, 4b) de bits par des éléments (8a, 8b) de commutation, une première résistance (R1) de terminaison étant en dérivation de la ligne (10, 11, 12) d'évaluation; et un convertisseur (1) d'impédance, dont l'entrée est reliée à la ligne (10, 11, 12) d'évaluation et dont la sortie peut être reliée individuellement à des deuxièmes entrées des lignes (4a, 4b) de bits et des lignes (5a, 5b) de mots par des éléments (7a, 7b, 9a, 9b) de commutation.

2. Mémoire magnétorésistive suivant la revendication 1, **caractérisée** **en ce que** la ligne (10, 11, 12) d'évaluation a une ligne (10) de connexion pour la liaison avec les lignes (4a, 4b) de bits et deux trajets (11, 12) d'évaluation qui peuvent être reliés individuellement à la ligne (10) de connexion par des éléments (20, 21) de commutation ; respectivement une résistance (R1, R2) de terminaison étant en dérivation des trajets (11, 12) d'évaluation ; chacun des deux trajets (11, 12) d'évaluation pouvant être relié par un élément (24, 25) de commutation à une entrée de l'évaluateur (2) de tension et à une capacité (C1, C2) montée en parallèle à celui-ci ; et chacun des deux trajets (11, 12) d'évaluation peut être relié par un élément (22, 23) de commutation à l'entrée du convertisseur (1) d'impédance et par une capacité (C3) en parallèle à l'entrée.

3. Mémoire magnétorésistive suivant la revendication 1 ou 2,

**caractérisée** **en ce qu'**elle comporte, en outre :

une première source (I1) de courant d'écriture, qui peut être reliée individuellement aux premières entrées des lignes (5a, 5b) de mots par des éléments (6a, 6b, 17) de commutation; et une deuxième source (I2) de courant d'écriture, qui peut être reliée individuellement aux premières extrémités des lignes (4a, 4b) de bits par des éléments (8a, 8b, 18) de commutation.

4. Mémoire magnétorésistive suivant l'une des revendications 1 à 3, **caractérisée** **en ce que** la liaison des lignes (4a, 4b) de bits à la ligne (10, 11, 12) d'évaluation s'effectue par un répartiteur (14) d'évaluateur ayant une élément (8a, 8b) de commutation pour chacune des lignes (4a, 4b) de bits.

5. Mémoire magnétorésistive suivant la revendication 4, **caractérisée** **en ce que** la liaison des lignes (4a, 4b) de bits avec la deuxième source (I2) de courant d'écriture s'effectue également par le répartiteur (14) d'évaluateur de la deuxième source (I2) de courant d'écriture et la ligne (10, 11, 12) d'évaluation pouvant être reliée au répartiteur (14) d'évaluateur par des éléments (18, 19) de commutation.

6. Mémoire magnétorésistive suivant l'une des revendications 1 à 5, **caractérisée** **en ce que** la liaison de la sortie du convertisseur (1) d'impédance avec les lignes (4a, 4b, 5a, 5b) de bits et de mots s'effectue par un répartiteur (15) tampon ayant un élément (7a, 7b, 9a, 9b) de commutation pour chaque ligne (4a, 4b, 5a, 5b) de bits et de mots.

7. Mémoire magnétorésistive suivant l'une des revendications 1 à 6, **caractérisée** **en ce que** la liaison de la source (U1) de tension de lecture avec les lignes (5a, 5b) de mots s'effectue par un répartiteur (13) de lecture ayant un élément (6a, 6b) de commutation pour chaque ligne (5a, 5b) de mots.

8. Mémoire magnétorésistive suivant la revendication 7, **caractérisée** **en ce que** la liaison de la première source (I1) de courant d'écriture avec les lignes (5a, 5b) de mots s'effectue également par le répartiteur (13) de lecture, la première source (I1) de courant d'écriture et la source (U1) de tension de lecture pouvant être reliées au répartiteur (13) de lecture par des éléments (13, 17) de commutation.

9. Mémoire magnétorésistive suivant l'une des revendications 1 à 8,
   **caractérisée**
   **en ce que** les éléments de commutation sont des transistors.

10. Procédé de lecture de cellules d'une mémoire magnétorésistive comprenant
    une configuration de cellules (3a, 3b, 3c, 3d) de mémoire magnétorésistive disposée suivant une multiplicité de rangées et/ou une multiplicité de colonnes ;
    une ligne (4a, 4b) de bits pour chacune des colonnes, qui est reliée à de premiers pôles des cellules (3a, 3b, 3c, 3d) de mémoire appartenant à la colonne ;
    une ligne (5a, 5b) de mots pour chacune des rangées, qui est reliée à des deuxièmes pôles des cellules (3a, 3c, 3b, 3d) de mémoire appartenant à la rangée ; le procédé ayant des stades suivants :

    A : application d'une source (U1) de tension de lecture au deuxième pôle d'une cellule (3a) de mémoire à lire ;
    B : évaluation de la tension chutant aux bornes d'une première résistance (R1) de terminaison par un évaluateur (2) de tension, la première résistance (R1) de terminaison et une première entrée de l'évaluateur (2) de tension étant reliées au premier pôle de la cellule (3a) de mémoire à lire ; et
    C : application de la tension chutant aux bornes de la première résistance (R1) de terminaison également à l'entrée d'un convertisseur (1) d'impédance et application de la tension à la sortie du convertisseur (1) d'impédance aux lignes (7b, 9b) de mots et de bits qui ne sont pas reliées à la cellule (3a) de mémoire à lire.

11. Procédé suivant la revendication 10,
    **caractérisé**
    **en ce que** la tension de sortie du convertisseur (1) d'impédance est égale à sa tension d'entrée.

12. Procédé suivant la revendication 10 ou 11,
    **caractérisé**
    **en ce que** l'on effectue sensiblement simultanément les stades A, B et C.

13. Procédé suivant l'une des revendications 10 à 12,
    **caractérisé**
    **en ce que** l'évaluation B comprend des stades suivants :

    B1 : liaison par une ligne (10, 11, 12) d'évaluation de la ligne (4a) de bits reliée à la cellule (3a) de mémoire à lire, à la première entrée de l'évaluateur (2) de tension, à la première résistance (R1) de terminaison et à l'entrée du convertisseur (1) d'impédance ; et
B2 : détermination de la tension s'appliquant à la première entrée dans l'évaluateur (2) de tension.

14. Procédé suivant l'une des revendications 10 à 13,
    **caractérisé**
    **en ce qu'**il comprend des stades supplémentaires suivants :

    D : mémorisation de la tension chutant aux bornes de la première résistance (R1) de terminaison dans une première et dans une troisième capacité (C1, C3) qui sont reliées à la première entrée de l'évaluateur (2) de tension et à l'entrée du convertisseur (1) d'impédance ;
    E : séparation de la première entrée de l'évaluateur (2) de tension et de la première capacité (C1) de la première résistance (R1) de terminaison ;
    F : séparation de l'entrée du convertisseur d'impédance et de la troisième capacité de la première résistance de terminaison ;
    G : séparation de la source (U1) de tension de lecture de la cellule (3a) de mémoire à lire ;
    H : séparation de la première résistance (R1) de terminaison de la cellule (3a) de mémoire à lire ;
    I : application de la tension s'appliquant à la sortie du convertisseur (1) d'impédance à toutes les lignes (4a, 4b, 5a, 5b) de mots et de bits ;
    J : application d'une première source (I1) de courant à la ligne de mots reliée au deuxième pôle de la cellule (3a) de mémoire à lire ;
    K : application d'une deuxième source (I2) de courant à la ligne de bits reliée au premier pôle de la cellule (3a) de mémoire à lire ;
    L : séparation de la première source (I1) de courant de la ligne de mots reliée au deuxième pôle de la cellule (3a) de mémoire à lire ;
    M : séparation de la deuxième source (I2) de courant de la ligne de bits reliée au premier pôle de la cellule (3a) de mémoire à lire ;
    N : séparation de la tension s'appliquant à la sortie du convertisseur (1) d'impédance du deuxième pôle de la cellule (3a) de mémoire à lire ;
    O : séparation de la tension s'appliquant à la sortie du convertisseur (1) d'impédance du premier pôle de la cellule (3a) de mémoire à lire ;
    P : liaison par la ligne (10, 11, 12) d'évaluation de la ligne de bits reliée à la cellule de mémoire à lire à la deuxième entrée d'évaluateur de tension, à la deuxième résistance (R2) de terminaison et à l'entrée du convertisseur d'impédance ;
    Q : application de la source (U1) de tension de lecture au deuxième pôle de la cellule (3a) de mémoire à lire

R : mémorisation de la tension chutant aux bornes de la deuxième résistance (R2) de terminaison dans une deuxième capacité (C2) parallèle à la première résistance (R2) de terminaison, la deuxième résistance (R2) de terminaison, la deuxième capacité (C2) et une deuxième entrée de l'évaluateur (2) de tension étant reliée au premier pôle de la cellule (3a) de mémoire à lire ;
S : comparaison dans l'évaluateur (2) de tension de la tension mémorisée dans la première et dans la deuxième capacité (C1, C2).

15. Procédé suivant la revendication 14, **caractérisé en ce que** l'on effectue sensiblement simultanément les stades A, B, C et D.

16. Procédé suivant la revendication 14 ou 15, **caractérisé en ce que** l'on effectue sensiblement simultanément les stades E et F.

17. Procédé suivant l'une des revendications 14 à 16, **caractérisé en ce que** l'on effectue sensiblement simultanément les stades G et H.

18. Procédé suivant l'une des revendications 14 à 17, **caractérisé en ce que** l'on effectue sensiblement simultanément les stades J et K.

19. Procédé suivant l'une des revendications 14 à 18, **caractérisé en ce que** l'on effectue sensiblement simultanément les stades L et M.

20. Procédé suivant l'une des revendications 14 à 19, **caractérisé en ce que** l'on effectue sensiblement simultanément les stades N, O et P.

21. Procédé suivant l'une des revendications 14 à 20, **caractérisé en ce que** l'on effectue sensiblement simultanément les stades Q et S.

FIG 1

FIG 2

EP 1 204 120 B1

FIG 3

EP 1 204 120 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1152429 A